# EUROPEAN PATENT APPLICATION

(11) **EP 1 630 706 A1**
(43) Date of publication of application: **01.03.2006**
(21) Application number: 05076976.9
(22) Date of filing: 29.08.2005
(51) Int. Cl.: G06F 17/50

(54) **Method for producing a set of related electrical engineering drawings.**

(30) Priority: 30.08.2004 NL 1026923
(71) Applicant: Yellax Holding B.V., 3404 DW Ijsselstein Ut (NL)
(72) Inventor: Vergeer, Petrus Johannes, 3404 DW Ijsselstein UT (NL)
(74) Representative: Brookhuis, Hendrik Jan Arnold

(57) **Abstract**

A method for producing a set of related electrical engineering drawings of an electrical engineering installation, said installation comprising one or more electrical engineering components, whereby the related electrical engineering drawings each represent a different aspect of the installation, said method using a CAD system comprising a computer and a computer-aided design program loaded thereon, said CAD system comprising a library file in which a plurality of predefined bundles are stored.

A predefined bundle comprises at least all graphically representable electrical engineering diagrams which are associated with the same electrical engineering component.

In a design procedure selection, all predefined bundles associated with one or more electrical engineering components which form part of the electrical engineering installation are selected,

For each aspect of the installation, the electrical engineering diagrams which relate to that aspect are grouped on the basis of the selected bundles, and the compilation of the electrical engineering drawing on the basis of the selected group of diagrams.

## Description

The present invention relates to the production of a set of related electrical engineering drawings using a CAD system, and possibly one or more other documents which relate to an electrical engineering installation.

A set of related electrical engineering drawings is normally required for the production and maintenance of an electrical engineering installation. For example, a drawing is required in which the complete main current diagram of all components of the installation is represented, and a drawing of the complete control current diagram.

CAD software is available on the market for the production of electrical engineering drawings of this type with the aid of a computer, for example under the name of Eplan - Caddy - Electrical Designer.

The drawings which are produced with the known CAD systems appear in practice to comprise an undesirable number of inaccuracies. These inaccuracies are sometimes not noticed during the design and production of the installation, so that the installation which is produced ultimately does not operate, or does not operate satisfactorily. Time-consuming and costly troubleshooting is then required in order to locate and correct the inaccuracies.

A further disadvantage of the known CAD systems is that a designer can easily make mistakes, so that a high degree of knowledge and quality are required from the designer in order to avoid mistakes.

The object of the invention is generally to propose an improved method for the production of a set of related electrical engineering drawings. The object of the method is specifically to enable a more efficient and more user-friendly production of the set of drawings, and possibly one or more other documents relating to the drawings.

In particular, the object of the invention is to propose a method whereby far fewer errors occur in the set of drawings.
A further object of the invention is to produce a computer program with which the method can be implemented.

The invention achieves one or more of the aforementioned objects by providing a method according to claim 1.

Further advantageous embodiments of the method according to the invention are described in the subclaims and in the following description with reference to the drawing.

The present invention furthermore relates to a computer-readable storage medium provided with a computer-executable program to carry out the method.

The present invention furthermore relates to a computer-aided design program that causes a computer to operate according to the method.

The present invention furthermore relates to a computer program which supports the relevant steps of the method, and which can interwork with a computer-aided design program, existing or otherwise, in order to implement the method described here for the production of a set of electrical engineering drawings.

The present invention also relates to a CAD system to carry out the method, comprising a computer, an input device (keyboard, mouse, etc.), a monitor, a printing device for drawings, and a computer-aided design program loaded into the memory of the computer, with which the method is implemented.

In the drawings:
Fig. 1 schematically shows a preferred embodiment of the method according to the invention; and
Fig. 2 shows, as an example, a predefined bundle of all the electrical engineering drawings associated with an electric motor, referred to as the "motor group".

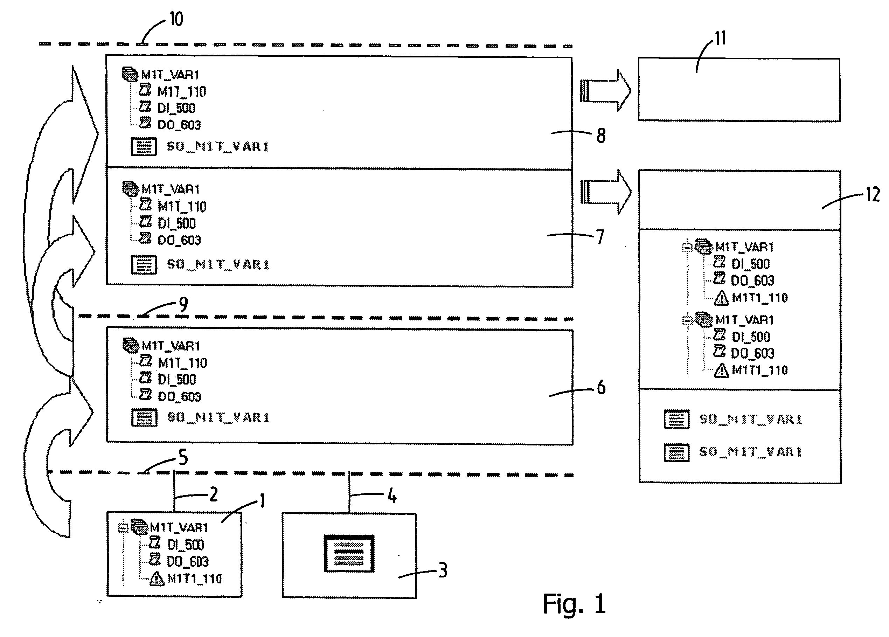

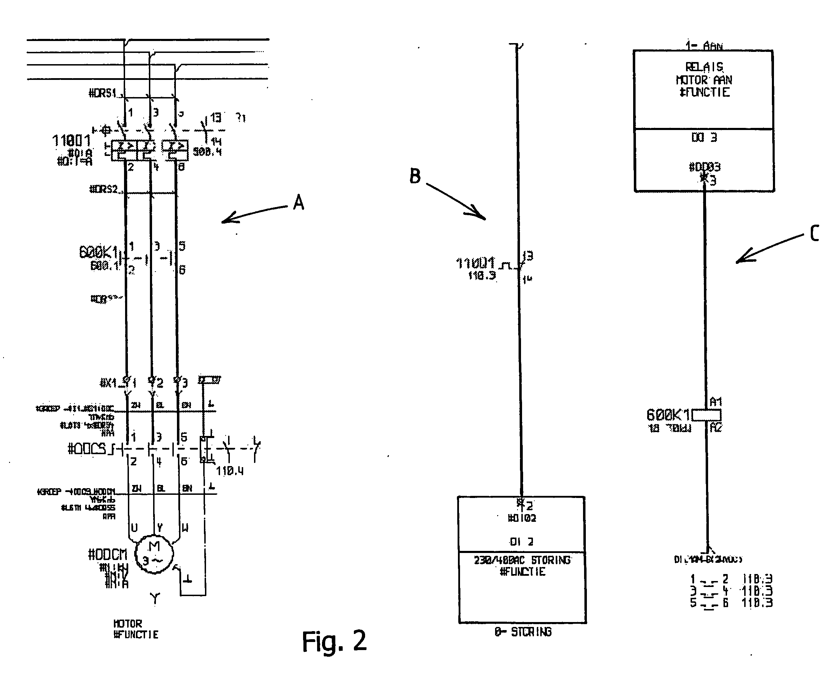

The method for producing a set of related electrical engineering drawings according to the invention will be explained below with reference to figures 1 and 2.

The starting point in this example is a CAD system for the production of electrical drawings which is already available on the market, for example Eplan - Caddy - Electrical Designer.

The CAD system includes a database in which associated graphically representable electrical engineering drawings are held for a large number of electrical engineering (standard) components. For example, these drawings relate to the main current and the control current of the electrical engineering component.

This database holds, for example, in order to power and control an electric motor, three drawings, i.e. a main current diagram M1T_110 and two control current diagrams DI_500 and DO_603. Of these diagrams, the version produced using the method according to the invention is shown in figure 2.

The main current diagram M1T_110 comprises a compilation of electrical engineering components, such as a contactor and a motor protection component.

The first control current diagram DI_500 relates to the digital input for signalling the motor protection (fault reporting). The second control current diagram DO_603 relates to the digital output for controlling the motor (start and stop). Said digital input and output can be connected to a programmable control unit, such as a PLC.

The three diagrams therefore relate to the same electrical engineering component, i.e. the "motor group".

These three diagrams are stored in the known CAD system as separate files, which is indicated schematically in figure 1 below. In the known method, the draughtsman wishing to produce drawings for the complete main current diagram and for the complete control current diagram must consider, for each drawing, which file must form part of these drawings.

It will be clear that, for example in the case of an installation with a large number of motors, the draughtsman may easily forget one diagram, so that, for example, the digital output of one of the motors is not included in the drawing.

The method according to the invention prevents this problem, for example in the following manner.

A user, often a manager, of the CAD system compiles a predefined bundle of all diagrams relating to the same electrical engineering component. In this example, this could be done by defining a "motor group" bundle, in programming language referred to as an "object", and the software-based creation of a "link" between the designation of that bundle on the one hand and all associated diagrams on the other hand.

This predefined bundle can be stored in a library file of the CAD system (see the middle of figure 1).

It is conceivable, as in the example shown, that a component will occur in a plurality of "dimensions", for example in the powering and control of an electric motor, the structure of the "motor group" will be identical, but the components will be adapted according to the power of the electric motor. In this case, the manager can predefine a bundle for each "dimension" and incorporate it in the library file, as indicated by the bundle name (or object name) "Motor group DOL .. kW".

In designing an installation incorporating one or more electric motors and associated "motor groups", the designer only has to make the relevant selection from the "motor groups" with the correct power (kW) from the library. All the diagrams associated with an electrical engineering component will then be automatically included in each bundle. It is then no longer possible to forget a diagram. Figure 1 shows that the designer has selected two different predefined bundles, i.e. a motor group DOL 1.5 kW to drive a discharge pump and a motor group DOL 22 kW to drive a conveyor belt.

In the method according to the invention, for each aspect of the installation, in this case the main current and the control current, the electrical engineering drawings relating to that aspect are then grouped by the software from the selected bundles. For each aspect, the designer therefore automatically obtains all of the drawings associated with that aspect. On the basis of each selected group of diagrams, the designer can then complete and print out the electrical engineering drawing.

The method preferably provides for improved handling of variables in the diagrams relating to the electrical engineering components.

In the example shown, it can be seen that one or more variables which can be graphically represented in the diagram are associated with each of the diagrams, said variables being able to assume a value which is to be entered by a user. These variables are therefore ultimately represented in the drawings.

The method provides that a user, normally the manager, of the CAD system, in defining a bundle, also checks whether interrelated variables, for example identical variables, occur in the various diagrams in that bundle. In the example shown (figure 2), it can be seen that a variable occurs in the diagram of the digital input which also occurs in the motor protection component in the main current diagram. A variable also occurs in the diagram of the digital output which is related to a variable in the main current diagram, and in this case is identical to it.

The method provides that the person who compiles the bundle defines a relationship, by means of the software, between variables in the different diagrams of the bundle. A relationship may consist in that the variables are identical, whereby an addition (for example one or more letters) possibly takes place in one variable in relation to the other, but may also consist of a formula/calculation. In the last case, a variable could, for example, be an input parameter of the calculation, and the other, related variable the result of the calculation. These relationships then form part of the predefined bundle.

The manager, or possibly at a later stage a designer, can assign a value to each variable.

In order to reduce the number of mistakes made, it can be provided that the manager, in defining a bundle, defines an input marker for each variable, i.e. a description of the characteristic of the variable concerned. For example, the characteristic of a variable is an I/O coding, an item designation, or a numerical value. For example, it is provided by means of the software that, in assigning the characteristic, a menu (for example a pull-down menu) is linked with the variable, so that the variable can define via that menu.

The manager, or, at a later stage, a designer, can assign a value to a variable or (in most cases the designer) can modify a variable. When the manager assigns a value, the value then forms part of the bundle.

If the manager or designer assigns or modifies a value of a variable which occurs in an identical manner in a plurality of diagrams from a bundle, and these variables are related in the aforementioned manner, the software causes all occurrences of these variables automatically to acquire the same value. This can be seen in figure 2, where identical variables have an identical value (assigned by the manager). It will be clear that, if a different form of relationship is defined between variables in the different diagrams of a bundle, suitable software will provide the related variables with the correct related value in these cases also.

As stated, the different diagrams will ultimately be placed in different but interrelated drawings. In the known CAD systems, the problem occurs that the assignment or modification of a variable in one drawing may take place without the same variable being adapted in a different drawing. The method described here avoids this problem.

A further variant provides that the bundle also comprises a set of computer instructions associated with the relevant component for programming the programmable control unit with which the relevant component interworks. This set may be incorporated in a different document, for example a text file which belongs with the drawings in the bundle. One or more variables may occur in this set also, which can be provided with a value by the manager or the designer. One or more of these variables may also be identical or related in a different manner to variables in the graphically representable diagrams. In a preferred embodiment, the invention provides that, in this case also, a relationship can be defined (by the software) between the variables, as explained above.

In figure 1, it can be seen that standardised machine (PLC) software is used, from which a selection is made in compiling the bundle, said selection being added to the bundle as a file SO_M1T_VAR1.

In compiling an installation through suitable selection of predefined bundles, a selection is thus also directly made of the associated computer instructions for the control unit. On the basis of this selection, the control engineer or programmer can effectively produce an overall design for the control program, whereby no computer instructions are forgotten.

It can furthermore be seen in figure 1 that, on the basis of the selected bundles, information can also be transferred to suitable ERP software, for example to prepare a proposal, place orders, for stock control, etc.

Explanation of figure 1:
Block 1:
   M1T_VAR1 Main Current Motor Group DOL
   DI_500 Digital input for motor protection switch
   DO_603 Digital output for contactor

2: Manager(s) electrical diagrams
Block 3: Standardised Machine (PLC) Software
4: Machine (PLC) Software
5: Management (Active)
6: Object: Motor group DOL ".. KW"
7: Conveyor belt, Object: Motor group DOL "22KW"
8: Discharge pump, Object: Motor group DOL "1.5KW"
9: Library
10: Project Compilation
11: ERP Software, proposal, pricing-orders, stock control items, accounts receivable/accounts payable
12: Project

Figure 2:
   A: Main current
   B: Digital input
   C: Digital output

## Claims

1. Method for producing a set of related electrical engineering drawings of an electrical engineering installation, said installation comprising one or more electrical engineering components, whereby the related electrical engineering drawings each represent a different aspect of the installation, said method using a CAD system comprising a computer and a computer-aided design program loaded thereon, said CAD system comprising a library file in which a plurality of predefined bundles are stored,
wherein a predefined bundle comprises all graphically representable electrical engineering diagrams which are associated with the same electrical engineering component,
and wherein the method further comprises the step of:
- selecting, in a design procedure, all predefined bundles associated with one or more electrical engineering components which form part of the electrical engineering installation,
and wherein the method further comprises:
- the grouping, for each aspect of the installation, on the basis of the selected bundles, of the electrical engineering diagrams which relate to that aspect, and the compilation of the electrical engineering drawing on the basis of the selected group of diagrams,
and whereby the method further comprises:
- the printing out of the set of related electrical engineering drawings.

2. Method according to claim 1, whereby a number of variables are associated with a plurality of electrical engineering diagrams, wherein said variables relate to the electrical engineering component and can assume a value which is to be entered by a user,
wherein the method further comprises the step of:
- the interrelating, in a predefinition procedure, of variables which occur at a plurality of locations and in a plurality of diagrams from the same bundle, and which are interrelated by means of a relationship,
and wherein the method further comprises the step of:
- assigning a value to one or more variables in a predefined bundle of diagrams, whereby an assignment of a value to a variable which is related by means of a relationship to one or more other variables in the bundle is transferred on the basis of this relationship to each related variable in the bundle.

3. Method according to claim 1 or 2, wherein, if the relevant electrical engineering component can be controlled by means of a programmable control unit, the bundle comprises a set of computer instructions associated with the relevant component for programming the control unit, said set preferably being incorporated in a different document associated with the bundle, for example a text file or spreadsheet file.

4. Method according to one or more of the preceding claims, wherein a bundle comprises at least one main current diagram and one control current diagram.

5. Method according to one or more of the preceding claims, wherein the user adapts one or more variables in the design procedure, wherein each adaptation of a variable in a bundle is transferred to all occurrences of that variable in that bundle.

6. Method for producing a set of related electrical engineering drawings of an electrical engineering installation, said electrical engineering drawings each representing a different aspect of the installation, said method using a CAD system comprising a computer and a computer-aided design program loaded thereon, said CAD comprising a database in which associated graphically representable electrical engineering diagrams are held for a large number of electrical engineering components, and wherein a number of variables are associated with a plurality of electrical engineering drawings, said variables being able to assume a value which is to be entered by a user,
wherein the method comprises the step of:
- the compilation by a user of the CAD system, in a predefinition procedure, of all the diagrams associated with the same electrical engineering component into a predefined bundle,
and wherein the method further comprises the step of:
- the interrelating by the user, in the predefinition procedure, of variables which occur at a plurality of locations and in a plurality of diagrams from the same bundle and which are interrelated by means of a relationship,
and wherein the method further comprises the step of:
- the assignment by the user of a value to one or more variables in a predefined bundle of diagrams, wherein the assignment of a value to a variable which is related by means of a relationship to one or more variables which occur at plurality of locations and in a plurality of diagrams is transferred on the basis of that relationship to each of those related variables,
and wherein the method further comprises the step of:
- the storage of a plurality of bundles predefined by the user with associated related variables in a library file,
and wherein the method further comprises the step of:
- the selection by a user, in a design procedure, of all predefined bundles associated with the one or more electrical engineering components which form part of the electrical engineering installation,
and wherein the method further comprises:
- the grouping of the diagrams relating to the same aspect on the basis of the selected bundles, and the compilation of an electrical engineering drawing on the basis of each selected group of diagrams,
and wherein the method further comprises:
- the printing out of the set of related electrical engineering drawings.

7. A computer-readable storage medium provided with a computer-executable program to carry out the method according to one or more of the preceding claims.

8. A computer-aided design program which causes a computer to operate according to the method as in one or more of the preceding claims 1-6.

9. A computer program which, in combination with a computer-aided design program, causes a computer to operate according to the method as in one or more of the preceding claims, wherein the computer program is set up to implement the following steps:
- The compilation, in a pre-definition procedure, of all diagrams associated with the same electrical engineering component into a predefined bundle,
- The storage of a plurality of predefined bundles in a library file,
- the selection, in a design procedure, of all predefined bundles associated with one or more electrical engineering components which form part of an electrical engineering installation,

10. Computer program according to claim 9, wherein the program is furthermore set up to implement the following steps:
- the interrelating, in the pre-definition procedure, of variables which occur in the same bundle, possibly in a plurality of diagrams, and which are interrelated by means of a relationship, and
- the assignment of a value to each variable in a predefined bundle of diagrams, wherein the assignment of a value to a variable which is related by means of a relationship to one or more other variables in the bundle is automatically transferred to each related variable, and
- the storage of a plurality of bundles predefined by the user with associated related variables in a library file.

11. A CAD system to carry out the method according to one or more of claims 1-6, comprising a computer, an input device, a display, a printing device and a computer-aided design program loaded into the memory of the computer, with which the method according to one or more of claims 1-6 is implemented.
